# EUROPÄISCHE PATENTSCHRIFT

(11) **EP 1 192 843 B1**
(45) Veröffentlichungstag und Bekanntmachung des Hinweises auf die Patenterteilung: **02.07.2003**
(21) Anmeldenummer: 00943582.7
(22) Anmeldetag: 11.05.2000
(51) Int. Cl.: H05K 5/02

(54) **GERÄTEANORDNUNG MIT EINER IN EINEM GEHÄUSE GEHALTENEN BAUGRUPPE**
DEVICE ARRANGEMENT WITH A STRUCTURAL COMPONENT MOUNTED IN A HOUSING
DISPOSITIF D'APPAREILS AVEC BOITIER CONTENANT UN BLOC DE COMPOSANTS

(30) Priorität: 30.06.1999 DE 19930143
(43) Veröffentlichungstag der Anmeldung: 03.04.2002
(73) Patentinhaber: Wincor Nixdorf International GmbH, 33106 Paderborn (DE)
(72) Erfinder: BAITZ, Günter, D-13629 Berlin (DE)
(86) Internationale Anmeldenummer: DE0001509
(87) Internationale Veröffentlichungsnummer: WO01003480

(56) Entgegenhaltungen:
- DE-A- 3 603 750
- DE-A- 19 610 559
- DE-U- 29 720 810
- US-A- 4 731 702
- US-A- 5 249 979

## Beschreibung

Die Erfindung betrifft eine Geräteanordnung nach dem Oberbegriff des Anspruchs 1, welche ein Gehäuse und eine in dem Gehäuse an einer Montagewand lösbar gehaltene Baugruppe umfaßt. Sie geht aus von der US 4 731 702 A.

Geräteanordnungen der genannten Art sind u.a. als Personal Computer (PC) bekannt. Beispielsweise zeigt das deutsche Gebrauchsmuster DE 297 20 810 U1 ein quaderförmiges Gehäuse, in dem die eigentliche Datenverarbeitungseinrichtung eines PC untergebracht ist. In die Frontwand des Gehäuses sind verschiedene Peripheriegeräte, nämlich ein Chipkartenleser, ein Diskettenlaufwerk und ein Bondrucker eingebaut. Hierfür ist an der Frontwand jeweils ein Einführschacht vorgesehen, der auch zum Einschieben eines Festplattenlaufwerkes dienen kann. Der Einbau eines Peripheriegerätes in den Einführschacht ist mühsam, denn es müssen, oft unter Zwischenlage von Distanzstücken oder Führungsleisten, auf engem Raum durch die Seitenwände des Einführschachtes Schrauben in Gewindelöcher des Peripheriegerätes eingeschraubt werden. Platzprobleme ergeben sich auch beim Aufstecken des Daten- und des Spannungsversorgungskabels auf entsprechende Stecker des Peripheriegerätes.

In der DE 36 03 750 A1 ist ein Automatisierungsgerät beschrieben, bei dem eine Reihe von Baugruppenträgern an eine Tragschiene angehängt und durch Schwenken gegen die Tragschiene mit Hilfe eines federbelasteten Riegels daran verrastet werden. Eine Lösung des Baugruppenträgers von der Tragschiene ist schwierig, weil der Riegel nur schwer zu erreichen ist. Auf die Baugruppenträger sind Baugruppen aufsetzbar, die dazu auf beiden Seiten mit Schwenkzapfen versehen sind. Die Baugruppen sind nach dem Einhängen der Schwenkzapfen in am Baugruppenträger angeordnete Nute um letztere schwenkbar. Die Baugruppen werden in ihrer an den jeweiligen Baugruppenträger geschwenkten Position mit einer Schraube gehalten.

In der US 4 731 702 A ist deshalb bereits eine Geräteanordnung vorgeschlagen worden, die ein Gehäuse mit einer durch eine Deckplatte verschließbaren Öffnung und eine in dem Gehäuse an einem das Gehäuse durchsetzenden als Montagestange ausgebildeten Montageelement lösbar gehaltene Baugruppe umfaßt. Die Baugruppe ist mittels eines hakenartigen Tragelements an die Montagestange angehängt und durch die Deckplatte in ihrer Position gehalten. Die Deckplatte und das Gehäuse bestehen wenigstens in einem Teilbereich aus einem elektrisch leitenden oder leitfähig beschichteten Material. In der genannten Position wird mit Hilfe der Deckplatte eine mechanische und galvanische Verbindung zwischen der Baugruppe und dem Gehäuse durch das Eingreifen von an der Deckplatte befindlichen Zapfen in komplementäre Ausnehmungen der Baugruppe hergestellt.

Aufgabe der Erfindung ist es, eine Geräteanordnung vorzuschlagen, die eine einfache Montage einer Baugruppe in einem Gehäuse gestattet.

Die Aufgabe wird durch die Merkmale des Anspruchs 1 gelöst.

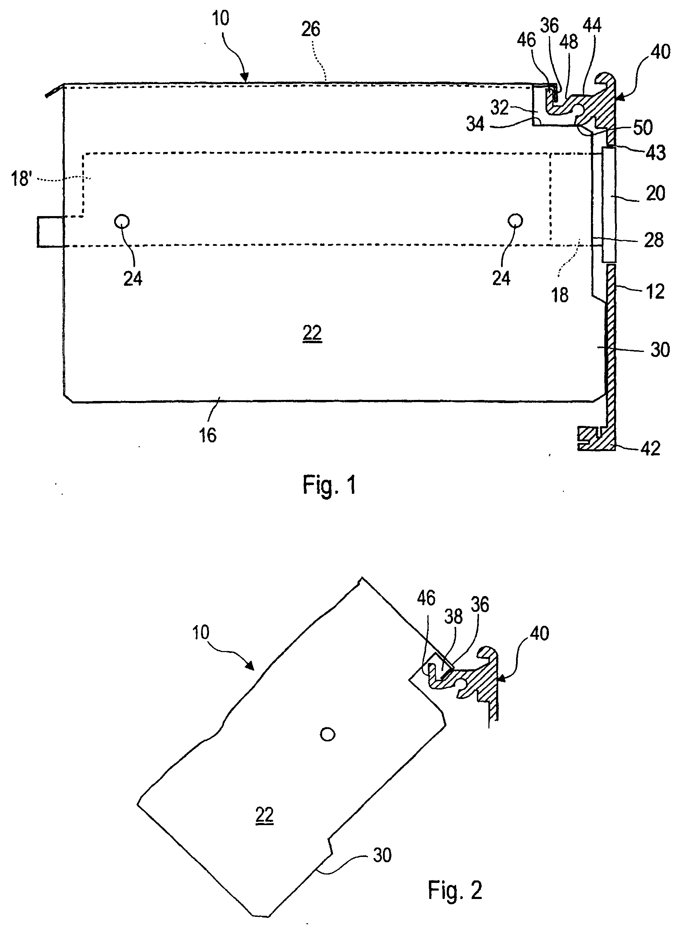

Eine Geräteanordnung nach der Erfindung umfaßt ein Gehäuse und eine in dem Gehäuse an einer Montagewand lösbar gehaltene Baugruppe, wobei die Baugruppe mittels eines hakenartigen Tragelements an eine Montagewand angehängt und durch eine Deckplatte gegen die Montagewand gedrückt und in ihrer Position gehalten wird. Dadurch ist eine werkzeug- und befestigungsmittelfreie Montage der Baugruppe möglich. Auch die räumlichen Einschränkungen bei der Montage der Anschlußkabel entfallen, denn die Kabel lassen sich an die hochgeschwenkte Baugruppe (Fig. 2) leicht anschließen. Erst danach wird die Baugruppe in ihre an der Montagewand anliegende Position (Fig. 1) geschwenkt und mit Hilfe der Deckplatte in dieser Position gehalten.

Erfindungsgemäß weist das Gehäuse an einer Seite eine durch die Deckplatte verschließbare Öffnung auf, die Montagewand hat eine der Öffnung nahe Tragekante und das Tragelement ist -in montiertem Zustand der Baugruppe gesehen- an einer der Montagewand zugekehrten Seite der Baugruppe mit einer die Tragekante übergreifenden Kehle versehen. Des Weiteren ist an der Baugruppe unterhalb des Tragelements ein Stützelement angeordnet, welches in montiertem Zustand der Baugruppe an der Montagewand anliegt. Die Deckplatte übt in ihrer die öffnung verschließenden Position ein das Stützelement gegen die Montagewand pressendes elastisches Andruckmoment auf die Baugruppe aus, und die Deckplatte ist mit dem Gehäuse verriegelbar.

Die räumliche Anordnung der Tragekante der Montagewand in der Nähe der Gehäuseöffnung erleichtert das Anhängen der Baugruppe in besonderem Maße. Dazu wird letztere mit Hilfe der Kehle des Tragelements einfach an die Tragekante gehängt. In der montierten Position der Baugruppe liegt das Stützelement an der Montagewand an. Wird nun die Deckplatte in ihre die Gehäuseöffnung verschließende Stellung gebracht und darin verriegelt, so wird die Baugruppe und damit das Stützelement gegen die Montagewand gepreßt.

In vorteilhafter Weise wird durch die Deckplatte zugleich mit der vorgenannten Haltefunktion eine galvanische Verbindung zwischen der Baugruppe und dem ebenfalls leitenden Gehäuse hergestellt. Dies wird dadurch erreicht, daß die Deckplatte und das Gehäuse zumindest in einem Bereich gegenseitiger Berührung aus einem elektrisch leitenden oder leitfähig beschichteten Material hergestellt ist. Eine zuverlässige Verbindung der Baugruppe mit dem Potential des Gehäuses ist damit gewährleistet. Die Baugruppe ist damit unverrückbar fest an ihrem Montageort gehalten und, wie erwähnt, zugleich galvanisch mit der Deckplatte und dem Gehäuse verbunden.

Zur Verbindung mit dem Gehäuse ist eine erste Kante der Deckplatte am oberen Rand der Montagewand gehalten. Vorzugsweise geschieht dies dadurch, daß die erste Kante der Deckplatte unter eine parallel zu der Tragekante verlaufende Halterippe oder in eine parallel zu der Tragekante verlaufende Nut gesteckt wird.

Entsprechend einer bevorzugten Weiterbildung der Erfindung umfaßt die Baugruppe einen Montagekäfig, in den wenigstens ein Peripheriegerät einbaubar oder eingebaut ist, und wobei die Tragekante und/oder das Stützelement an dem Montagekäfig angebracht ist (sind). Auf diese Weise werden alle mechanischen Beanspruchungen wie z.B. der Anpreßdruck der Deckplatte auf die Baugruppe und des Stützelements gegen die Montagewand von dem eigentlichen Peripheriegerät bzw. den Peripheriegeräten ferngehalten.

Vorzugsweise wird die Montagewand durch eine Seitenwand des Gehäuses, insbesondere dessen Vorderwand dargestellt. Eine zusätzliche Wand erübrigt sich dann.

Die Montagewand ist vorzugsweise aus einem Stranggußprofil hergestellt.

Weitere Merkmale und Vorteile der Erfindung ergeben sich aus der folgenden Beschreibung zweier Ausführungsbeispiele, welche an Hand der beigefügten Zeichnung erläutert werden. Es zeigt
- Fig. 1: eine Baugruppe in Seitenansicht, welche an die Vorderwand gemäß einem ersten Ausführungsbeispiel eines Gehäuses angehängt ist,
- Fig. 2: eine Teilansicht der Anordnung aus Fig. 1 in einer Montage-Zwischenposition,
- Fig. 3: ein Gehäuse gemäß dem ersten Ausführungsbeispiel in einer perspektivischen Draufsicht,
- Fig. 4: eine Teilansicht eines Schnitts durch das Gehäuse entlang einer Schnittlinie IV-IV in Fig. 3.
- Fig. 5: eine Teilansicht einer Baugruppe, welche an eine Vorderwand gemäß einem zweiten Ausführungsbeispiel eines Gehäuses angehängt ist, in geschnittener Seitenansicht.

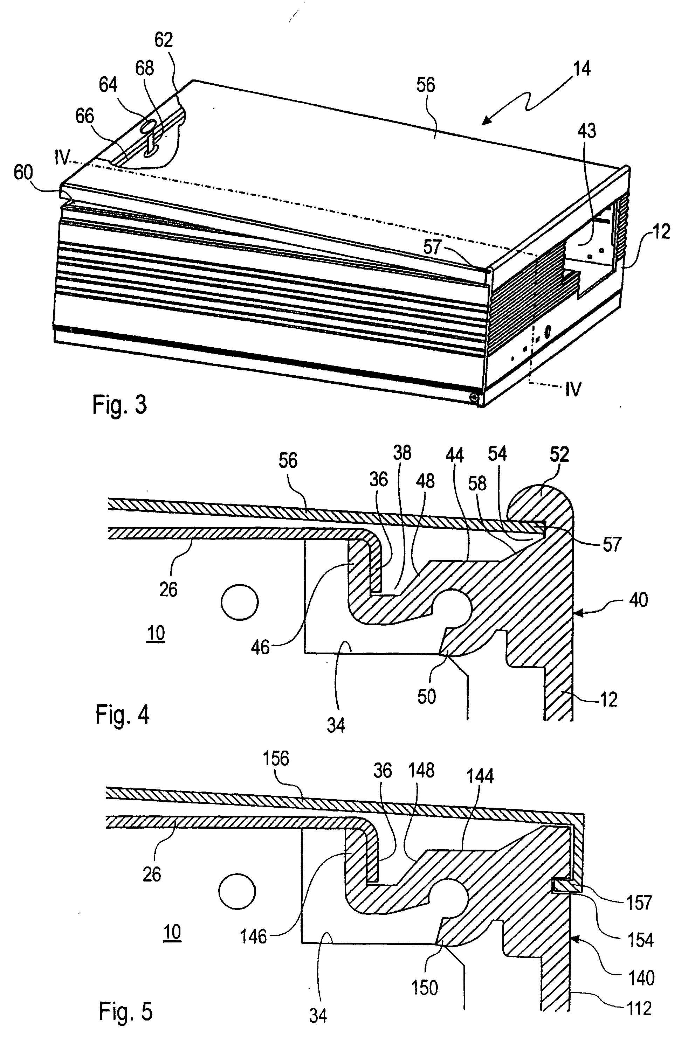

Fig. 1 zeigt eine Baugruppe 10 in Seitenansicht, welche an die geschnitten dargestellte Vorderwand 12 gemäß einem ersten Ausführungsbeispiel eines Gehäuses 14 (Fig. 3) angehängt ist. Die Baugruppe 10 besteht aus einem Montagekäfig 16 mit einem kopfstehenden U-förmigen Querschnittsprofil, in den ein Peripheriegerät 18 oder 18' eingebaut ist. Bei dem Peripheriegerät kann es sich z.B. um ein CD-Laufwerk 18 handeln, welches ein von außerhalb des Gehäuses 14 zu bedienendes Bedienfeld 20 mit bekannten und deshalb nicht dargestellten Bedienelementen umfaßt. Unterhalb des CD-Laufwerks 18 ist genügend Platz beispielsweise für ein Diskettenlaufwerk. Bei dem Peripheriegerät kann es sich aber auch um ein Festplattenlaufwerk 18' handeln, welches kein von außerhalb des Gehäuses 14 zu bedienendes Bedienfeld hat und deshalb weiter hinten im Montagekäfig 16 eingebaut werden kann.

Die Seitenwände 22 (nur die linke Seitenwand ist in Fig. 1 zu sehen) des Montagekäfigs 16 sind bei dessen in das Gehäuse 14 eingebautem Zustand senkrecht zur Vorderwand 12 des Gehäuses 14 ausgerichtet. Sie sind mit Durchgangslöchern 24 für nicht dargestellte Schrauben versehen, die das Peripheriegerät 18, 18' im Montagekäfig 16 halten. Die Seitenwände 22 sind oben durch eine Mittelplatte 26 verbunden. An die der Vorderwand 12 zugewandte Kante 28 jeder Seitenwand 22 ist bei dem der Mittelplatte 26 fernen Ende ein Stützelement 30 angeformt. An dem der Mittelplatte 26 nahen Ende weist jeder Seitenwand 22 einen rechteckigen Ausschnitt 32 auf, dessen nach oben weisende Kante 34 parallel zu der Mittelplatte 26 verläuft. Die Mittelplatte 26 überragt die Ausschnitte 32 und ist in deren Bereich rechtwinklig in deren Richtung abgebogen, so daß sich ein hakenartiges Tragelement 36 mit einer nach unten offenen Kehle 38 ergibt.

Die Vorderwand 12 des Gehäuses 14 ist aus Leichtmetall in einem Stranggußverfahren hergestellt. An ihrem oberen Rand ist an der Vorderwand 12 ein Kopfteil 40 und am unteren Rand ein Fußteil 42 ausgebildet. Im Bereich des Bedienfeldes 20 ist die Vorderwand 12 mit einem Durchbruch 43 versehen, dessen Lichtmaße den Außenabmessungen des Bedienfeldes 20 angepaßt sind.

Das Kopfteil 40 weist einen zum Gehäuseinneren weisenden Vorsprung 44 auf, an dessen Ende eine hakenartig nach oben weisende Tragekante 46 ausgebildet ist. Parallel und im Abstand zu der Tragekante 46 verläuft eine Einführschräge 48. An die Unterseite des Kopfteils 40 ist eine ebenfalls parallel zu der Tragekante 46 verlaufende Begrenzungsrippe 50 angeformt. Das Kopfteil 40 wird von einer parallel zu der Tragekante 46 verlaufenden Halterippe 52 überragt, die eine Aufnahmenut 54 für eine erste Kante 57 einer Deckplatte 56 nach oben begrenzt. Nach unten wird die Aufnahmenut 54 durch eine zweite Einführschräge 58 begrenzt.

Fig. 3 zeigt das Gehäuse 14 in einer perspektivischen Draufsicht. Das Gehäuse 14 ist quaderförmig mit einer obenliegenden Öffnung 60, die durch die Deckplatte 56 verschließbar ist. Die Deckplatte 56 ist bei ihrer der ersten Kante 57 fernen zweiten Kante 62 mit einem ersten Riegelelement 64 versehen, das mit einem in die Rückwand 66 des Gehäuses 14 eingebauten zweiten Riegelelement 68 zusammenwirkt. Deckel-, Klappen- und Türverriegelungen sind in vielfältigen Ausführungsformen bekannt. Die hier eingesetzte Verriegelung kann in bekannter Weise durch eine Handhabe oder durch einen Schlüssel verstellbar sein.

Nachfolgend wird der Einbau der Baugruppe 10 in das Gehäuse 14 beschrieben. Zunächst wird die Deckplatte 56 vom Gehäuse 14 abgenommen, so daß die Öffnung 60 frei liegt. Die Baugruppe 10 wird, wie in Fig. 2 gezeigt, um ca. 45° so nach unten geneigt, daß die Stützelemente 30 schräg nach unten weisen. In dieser Ausrichtung wird die Baugruppe 10 von oben in das Gehäuse 14 eingeführt und mit ihrem Tragelement 36 an die Tragekante 46 angehängt. Die Einführschäge 48 erleichtert dabei eine lagerichtige Positionierung. Anschließend wird die Baugruppe 10 in die in Fig. 1 gezeigte Position geschwenkt, bis die Stützelemente 30 an der Vorderwand 12 anliegen. Dabei wirkt die Kante 34 des Ausschnitts 32 mit der Begrenzungsrippe 50 im Sinne einer festen Anlage des Tragelements 36 an der Tragekante 46 zusammen. Nun wird die Deckplatte 56 von hinten mit ihrer ersten Kante 57 in die Aufnahmenut 54 geschoben. Sie liegt dabei, wie Fig. 4 zu entnehmen ist, auf der Baugruppe 10 auf, so daß ihre zweite Kante 62 von der Oberkante der Rückwand 66 des Gehäuses 14 absteht (Fig. 3). Wird nun die Deckplatte 56 auf das Gehäuse 14 niedergedrückt und mit der Rückwand 66 verriegelt, so verformt sich wenigstens eines der Elemente Tragelement 36, Tragekante 46 und Deckplatte 56 elastisch. Zwischen der Vorderwand 12 und der Deckplatte 56 einerseits und zwischen der Deckplatte 56 und der Baugruppe 10 andererseits besteht also ein ständiger Kontaktdruck, der für eine zuverlässige galvanische Verbindung zwischen diesen Bauelementen sorgt. Zugleich wird die Baugruppe in ihrer Position fixiert.

Fig. 5 zeigt eine geschnittene Teilansicht entsprechend Fig. 4, bei der die Baugruppe 10 an eine Vorderwand 112 gemäß einem zweiten Ausführungsbeispiel eines Gehäuses angehängt ist. An ihrem oberen Rand ist an der Vorderwand 112 ein Kopfteil 140 und am unteren Rand ein Fußteil ausgebildet, das dem Fußteil 42 in Fig. 1 entspricht und deshalb nicht dargestellt ist.

Das Kopfteil 140 weist einen zum Gehäuseinneren weisenden Vorsprung 144 auf, an dessen Ende eine hakenartig nach oben weisende Tragekante 146 ausgebildet ist. Parallel und im Abstand zu der Tragekante 146 verläuft auch hier eine Einführschräge 148. An die Unterseite des Kopfteils 140 ist eine ebenfalls parallel zu der Tragekante 146 verlaufende Begrenzungsrippe 150 angeformt. Auf der Außenseite der Vorderwand 112 ist im Bereich des Kopfteils 140 eine parallel zu der Tragekante 146 verlaufende Aufnahmenut 154 für eine erste Kante 157 einer Deckplatte 156 eingeformt.

Die erste Kante 157 der Deckplatte 156 ist rechtwinklig nach unten und dann in Richtung der Baugruppe 10 zurückgebogen. Im übrigen entspricht die Deckplatte 156 der Deckplatte 56 des ersten Ausführungsbeispiels.

Der Einbau der Baugruppe 10 erfolgt wie oben beschrieben,
wobei die Baugruppe 10 mit ihrem Tragelement 36 an die Tragekante 146 angehängt wird. Die Deckplatte 156 wird von vorne auf das Gehäuse 14 geschoben, bis sie mit ihrer ersten Kante 157 in die Aufnahmenut 154 eingreift. Sie liegt dabei wie die Deckplatte 56 des ersten Ausführungsbeispiels und wie in Fig. 5 dargestellt, auf der Baugruppe 10 auf, so daß ihre zweite Kante von der Oberkante der Rückwand 66 des Gehäuses 14 absteht (Fig. 3). Anschließend wird die Deckplatte 156 auf das Gehäuse 14 niedergedrückt und mit der Rückwand 66 verriegelt. Die Anordnung gemäß dem zweiten Ausführungsbeispiel hat den Vorteil, daß die Oberseite der Geräteanordnung völlig glatt ist.

### Bezugszeichenliste

- 10: Baugruppe
- 12: Vorderwand von 14
- 14: Gehäuse
- 16: Montagekäfig
- 18: CD-Laufwerk
- 18': Festplattenlaufwerk
- 20: Bedienfeld von 18
- 22: Seitenwand von 16
- 24: Durchgangsloch
- 26: Mittelplatte von 16
- 28: Kante von 22
- 30: Stützelement
- 32: Ausschnitt
- 34: Kante von 32
- 36: Tragelement
- 38: Kehle
- 40: Kopfteil von 12
- 42: Fußteil von 12
- 43: Durchbruch in 12
- 44: Vorsprung
- 46: Tragekante
- 48: Einführschräge
- 50: Begrenzungsrippe
- 52: Halterippe
- 54: Aufnahmenut
- 56: Deckplatte
- 57: erste Kante von 56
- 58: zweite Einführschräge
- 60: Öffnung
- 62: zweite Kante von 56
- 64: erstes Riegelelement
- 66: 66 Rückwand von 14
- 68: zweites Riegelelement

- 112: Vorderwand
- 140: Kopfteil
- 144: Vorsprung
- 146: Tragekante
- 148: Einführschräge
- 150: Begrenzungsrippe
- 154: Aufnahmenut
- 156: Deckplatte
- 157: erste Kante von 156

## Patentansprüche

1. Geräteanordnung, umfassend ein Gehäuse (14) mit einer durch eine Deckplatte (56, 156) verschließbaren Öffnung (60) und eine in dem Gehäuse (14) an einer Montagewand (12, 112) lösbar gehaltene Baugruppe (10), wobei die Baugruppe (10) mittels eines hakenartigen Tragelements (36) an die Montagewand (12, 112) angehängt und durch die Deckplatte (56, 156) in ihrer Position gehalten wird, die Deckplatte (56, 156) und das Gehäuse (14) wenigstens in einem Teilbereich aus einem elektrisch leitenden oder leitfähig beschichteten Material besteht und in der genannten Position mit Hilfe der Deckplatte (56, 156) eine galvanische Verbindung zwischen der Baugruppe (10) und dem Gehäuse (14) hergestellt wird,
**dadurch gekennzeichnet,**
**daß** die Montagewand (12, 112) eine der Öffnung (60) nahe Tragekante (46, 146) aufweist,
**daß** das Tragelement (36) -in montiertem Zustand der Baugruppe (10) gesehen- an einer der Montagewand (12, 112) zugekehrten Seite der Baugruppe (10) mit einer die Tragekante (46, 146) umfassenden Kehle (38) versehen ist,
**daß** an der Baugruppe (10) unterhalb des Tragelements (36) ein Stützelement (30) angeordnet ist, welches in montiertem Zustand der Baugruppe (10) an der Montagewand (12, 112) anliegt,
**daß** die Deckplatte (56, 156) in ihrer die Öffnung (60) verschließenden Position ein das Stützelement (30) gegen die Montagewand (12, 112) pressendes elastisches Andruckmoment auf die Baugruppe (10) ausübt,
**daß** die Deckplatte (56, 156) mit dem Gehäuse (14) verriegelbar ist.

2. Geräteanordnung nach Anspruch 1, **dadurch gekennzeichnet, daß** die galvanische Verbindung zwischen der Baugruppe (10) und dem Gehäuse (14) durch das elastische Andruckmoment der Deckplatte (56, 156) hergestellt wird.

3. Geräteanordnung nach Anspruch 1 oder 2, **dadurch gekennzeichnet, daß** eine erste Kante der (57, 157) Deckplatte (56, 156) am oberen Rand der Montagewand (12, 112) gehalten ist.

4. Geräteanordnung nach Anspruch 3, **dadurch gekennzeichnet, daß** die erste Kante (57, 157) der Deckplatte (56, 156) unter eine parallel zu der Tragekante (46, 146) verlaufende Halterippe (52) oder in eine parallel zu der Tragekante (46, 146) verlaufende Nut (54, 154) steckbar oder gesteckt ist.

5. Geräteanordnung nach einem der vorhergehenden Ansprüche, **dadurch gekennzeichnet,**
**daß** die Deckplatte (56; 156) auf einer ihr benachbarten Fläche (26) der Baugruppe (10) zumindest in einem dem Tragelement (36) fernen Bereich so aufliegt, daß ihre der ersten Kante (57; 157) gegenüberliegende zweite Kante (62) von dem Gehäuse (14) absteht,
**daß** durch Miederdrücken der zweiten Kante (62) auf das Gehäuse (14) die Tragekante (46; 146) und/oder das Tragelement (36) elastisch so verformt wird, daß die Deckplatte (56; 156) ein elastisches Andruckmoment auf die Baugruppe (10) ausübt, und
**daß** die Deckplatte (56, 156) im niedergedrückten Zustand mit dem Gehäuse (14) verriegelbar ist.

6. Geräteanordnung nach einem der vorhergehenden Ansprüche, **dadurch gekennzeichnet, daß** die Baugruppe (10) einen Montagekäfig (16) umfaßt, in den wenigstens ein Peripheriegerät (18, 18') einbaubar oder eingebaut ist, und daß die Tragekante (36) und/oder das Stützelement (30) an dem Montagekäfig (16) angebracht ist (sind).

7. Geräteanordnung nach einem der vorhergehenden Ansprüche, **dadurch gekennzeichnet, daß** die Montagewand eine Seitenwand des Gehäuses, insbesondere dessen Vorderwand (12, 112) ist.

8. Geräteanordnung nach den Ansprüchen 6 und 7, **dadurch gekennzeichnet, daß** ein Peripheriegerät (18) mit einem von außerhalb des Gehäuses (14) zu bedienenden Bedienfeld (20) so in den Montagekäfig (16) eingebaut ist, daß das Bedienfeld (20) das Stützelement (30) in Richtung der Seitenwand, insbesondere der Vorderwand (12) überragt, und daß in die Seitenwand, insbesondere die Vorderwand (12) ein der Aufnahme des Bedienfeldes (20) dienender Durchbruch (43) eingeformt ist.

9. Geräteanordnung nach einem der vorhergehenden Ansprüche, **dadurch gekennzeichnet, daß** die Montagewand (12, 112) aus einem Stranggußprofil hergestellt ist.

## Claims

1. Device arrangement comprising a housing (14), with an opening (60) which can be closed by a cover panel (56, 156), and a subassembly (10) which is retained in a releasable manner in the housing (14) on an installation wall (12, 112), it being the case that the subassembly (10) is suspended on the installation wall (12, 112) by means of a hook-like mounting element (36) and is retained in its position by the cover panel (56, 156), the cover panel (56, 156) and the housing (14) consist, at least in a sub-region, of an electrically conductive or conductively coated material, and, in the abovementioned position, an electrical connection is produced between the subassembly (10) and the housing (14) with the aid of the cover panel (56, 156),
**characterized**
**in that** the installation wall (12, 112) has a mounting edge (46, 146) in the vicinity of the opening (60),
**in that** - as seen in the installed state of the subassembly (10) - the mounting element (36) is provided, on a side of the subassembly (10) which is directed towards the installation wall (12, 112), with a channel (38) which encloses the mounting edge (46, 146),
**in that** arranged on the subassembly (10), beneath the mounting element (36), is a supporting element (30) which, in the installed state of the subassembly (10), butts against the installation wall (12, 112),
**in that**, in its position in which it closes the opening (60), the cover panel (56, 156) subjects the subassembly (10) to an elastic pressure-exerting torque which presses the supporting element (30) against the installation wall (12, 112), in that the cover panel (56, 156) can be locked to the housing (14).

2. Device arrangement according to Claim 1,
**characterized in that** the electrical connection between the subassembly (10) and the housing (14) is produced by the elastic pressure-exerting torque of the cover panel (56, 156).

3. Device arrangement according to Claim 1 or 2,
**characterized in that** a first edge (57, 157) of the cover panel (56, 156) is retained at the top border of the installation wall (12, 112).

4. Device arrangement according to Claim 3,
**characterized in that** the first edge (57, 157) of the cover panel (56, 156) can be, or is, plugged beneath a retaining rib (52), which runs parallel to the mounting edge (46, 146), or into a groove (54, 154), which runs parallel to the mounting edge (46, 146).

5. Device arrangement according to one of the preceding claims, **characterized**
**in that** the cover panel (56; 156) rests on an adjacent surface (26) of the subassembly (10) at least in a region which is remote from the mounting element (36), such that its second edge (62), which is located opposite the first edge (57; 157), projects from the housing (14),
**in that**, by virtue of the second edge (62) being pressed down onto the housing (14), the mounting edge (46; 146) and/or the mounting element (36) are/is elastically deformed such that the cover panel (56; 156) subjects the subassembly (10) to an elastic pressure-exerting torque, and in that, in the pressed-down state, the cover panel (56, 156) can be locked to the housing (14).

6. Device arrangement according to one of the preceding claims, **characterized in that** the subassembly (10) comprises an installation cage (16) in which at least one peripheral device (18, 18') can be, or is, installed, and **in that** the mounting edge (36) and/or the supporting element (30) are/is fitted on the installation cage (16).

7. Device arrangement according to one of the preceding claims, **characterized in that** the installation wall is a side wall of the housing, in particular the front wall (12, 112) thereof.

8. Device arrangement according to Claims 6 and 7, **characterized in that** a peripheral device (18) with a control panel (20) which is to be operated from outside the housing (14) is installed in the installation cage (16) such that the control panel (20) projects beyond the supporting element (30) in the direction of the side wall, in particular of the front wall (12), and **in that** a through-passage (43) serving for accommodating the control panel (20) is formed in the side wall, in particular the front wall (12).

9. Device arrangement according to one of the preceding claims, **characterized in that** the installation wall (12, 112) is produced from a continuously cast profile.

## Revendications

1. Arrangement d'appareils qui comprend un boîtier (14) avec une ouverture (60) qu'on peut fermer par une plaque de recouvrement (56, 156) et un module (10) maintenu de façon amovible sur une paroi de montage (12, 112) dans le boîtier, le module (10) étant accroché à la paroi de montage (12, 112) à l'aide d'un élément de support (36) en crochet et étant maintenu dans sa position par la plaque de recouvrement (56, 156), la plaque de recouvrement (56, 156) et le boîtier (14) étant constitués au moins dans une zone partielle d'un matériau électroconducteur ou revêtu de façon conductrice et une liaison galvanique entre le module (10) et le boîtier (14) étant établie dans ladite position à l'aide de la plaque de recouvrement (56, 156),
**caractérisé en ce que** la paroi de montage (12, 112) présente une arête de support (46, 146) proche de l'ouverture (60),
l'élément de support (36) - vu lorsque le module (10) est en état monté - sur un côté du module (10) tourné vers la paroi de montage (12, 112) est muni d'une gorge (38) qui entoure l'arête de support (46, 146),
sur le module (10) au-dessous de l'élément de support (36) est disposé un élément d'appui (30) qui est appliqué sur la paroi de montage (12, 112) en état monté du module (10),
dans sa position qui ferme l'ouverture (60), la plaque de recouvrement (56, 156) exerce sur le module (10) un moment de pression élastique qui presse l'élément d'appui (30) contre la paroi de montage (12, 112),
la plaque de recouvrement (56, 156) peut être verrouillée avec le boîtier (14).

2. Arrangement d'appareils selon la revendication 1 **caractérisé en ce que** la liaison galvanique entre le module (10) et le boîtier (14) est établie par le moment de pression élastique de la plaque de recouvrement (56, 156).

3. Arrangement d'appareils selon la revendication 1 ou 2 **caractérisé en ce qu'**une première arête (57, 157) de la plaque de recouvrement (56, 156) est maintenue sur le bord supérieur de la paroi de montage (12, 112).

4. Arrangement d'appareils selon la revendication 3 **caractérisé en ce que** la première arête (57, 157) de la plaque de recouvrement (56, 156) est engagée ou peut être engagée sous une nervure de maintien (52) qui s'étend parallèlement à l'arête de support (46, 146) ou dans une rainure (54, 154) qui s'étend parallèlement à l'arête de support (46, 146).

5. Arrangement d'appareils selon l'une des revendications précédentes
**caractérisé en ce que** la plaque de recouvrement (56 ; 156) sur une surface (26) - qui l'avoisine - du module (10), au moins dans une zone éloignée de l'élément de support (36), est disposée de telle sorte que sa deuxième arête (62) opposée à la première arête (57 ; 157) soit à distance du boîtier (14),
qu'en pressant vers le bas la deuxième arête (62) sur le boîtier (14), l'arête de support (46 ; 146) et/ou l'élément de support (36) est élastiquement déformé de telle manière que la plaque de recouvrement exerce un moment de pression élastique sur le module (10) et
que la plaque de recouvrement (56 ; 156) peut être verrouillée avec le boîtier (14) dans l'état poussé vers le bas.

6. Arrangement d'appareils selon l'une des revendications précédentes
**caractérisé en ce que** le module (10) comprend une cage de montage (16) dans laquelle est monté ou peut être monté au moins un périphérique (18, 18') et que l'arête de support (36) et/ou l'élément d'appui (30) est (sont) appliqué(s) sur la cage de montage (16).

7. Arrangement d'appareils selon l'une des revendications précédentes
**caractérisé en ce que** la paroi de montage est une paroi latérale du boîtier, en particulier sa paroi avant (12, 112).

8. Arrangement d'appareils selon les revendications 6 et 7 **caractérisé en ce qu'**un périphérique (18) avec un panneau de commande (20) à commander de l'extérieur du boîtier (14) est monté dans la cage de montage (16) de telle manière que le panneau de commande (20) dépasse de l'élément d'appui (30) en direction de la paroi latérale, en particulier de la paroi avant (12), et que dans la paroi latérale, en particulier dans la paroi avant (12), est ménagé un passage (43) qui sert à loger le panneau de commande (20).

9. Arrangement d'appareils selon l'une des revendications précédentes
**caractérisé en ce que** la paroi de montage (12, 112) est fabriquée dans un profilé en coulée continue.
